Europäisches Patentamt

(19) European Patent Office

Office européen des brevets

(11) Numéro de publication: **0 149 942**
**B1**

(12) **FASCICULE DE BREVET EUROPEEN**

(45) Date de publication du fascicule du brevet:
**24.05.89**

(21) Numéro de dépôt: **84402646.8**

(22) Date de dépôt: **19.12.84**

(51) Int. Cl.⁴: **C 30 B 11/00,** C 30 B 29/52,
C 30 B 33/00

(54) **Alliage monocristallin à matrice à base de nickel.**

(30) Priorité: **29.12.83 FR 8320986**

(43) Date de publication de la demande:
**31.07.85 Bulletin 85/31**

(45) Mention de la délivrance du brevet:
**24.05.89 Bulletin 89/21**

(84) Etats contractants désignés:
**BE DE FR GB IT SE**

(56) Documents cités:
**EP-A- 0 052 911**
**EP-A- 0 063 511**
**FR-A- 2 463 192**
**FR-A- 2 512 837**
**US-A- 4 222 794**

**T. Khan et al.: "Single Crystal Superalloys for Turbine Blades" presented at the 11th. Symposium "Steels and Special Alloys for Aerospace", 6.6.1985, Le Bourget**

(73) Titulaire: **ASSOCIATION POUR LA RECHERCHE ET LE DEVELOPPEMENT DES METHODES ET PROCESSUS INDUSTRIELS (ARMINES), 60, Boulevard Saint-Michel, F-75272 Paris Cédex 06 (FR)**
Titulaire: **Office National d'Etudes et de Recherches Aérospatiales (O.N.E.R.A.), 29 Avenue de la Division Leclerc, F-92320 Châtillon-sous-Bagneux (FR)**
Titulaire: **SOCIETE NATIONALE D'ETUDE ET DE CONSTRUCTION DE MOTEURS D'AVIATION, "S.N.E.C.M.A.", 2 Boulevard Victor, F-75015 Paris (FR)**
Titulaire: **IMPHY S.A., Immeuble Elysées La Défense 19 Le Parvis, F-92072 ParisLa Défense (FR)**

(72) Inventeur: **Fredholm, Allan, 4, rue du Bel Air, F-91000 Evry (FR)**
Inventeur: **Khan, Tasadduq, 18, parc de Diane, F-78350 Jouy en Josas (FR)**
Inventeur: **Theret, Jean-Marc, Clément, F., 20, rue Victor Bart, F-78000 Versailles (FR)**
Inventeur: **Davidson, James, Henry, Les 4 Cheminées, F-58640 Varennes Vauzelles (FR)**

(74) Mandataire: **Molnat, François, S.N.E.C.M.A. Service des Brevets Boîte Postale 81, F-91003 Evry Cédex (FR)**

## Description

L'invention concerne des alliages monocristallins à matrice à base de nickel, sans addition intentionnelle de carbone, de bore ou de zirconium.

Depuis plusieurs années, les applications aéronautiques de ces alliages (fabrication d'aubes de turbomachines) ont fait sentir le besoin de mettre au point des familles d'alliages particulièrement performants, assurants une bonne tenue au fluage. Les documents FR-A 2 503 188, FR-A 2 512 837, FR-A 2 513 269, EP-A 0 052 911 témoignent de ces recherches.

En particulier, EP-A-0 063 511 – sous priorité de la demande FR-A-2 503 188 – décrit une famille d'alliages dont la composition en poids est définie par les teneurs Al 5,4 à 6,2%; Co 4 à 7%; Cr 6 à 9%; Mo 0 à 2,5%; Ta 5,5 à 8%; Ti 0 à 1%; W 7 à 9% et Ni complément à 100. Il cite un exemple d'alliage monocristallin de composition pondérale Co 5%, Cr 8%, Mo 0,5%, W 8%, Al 5,5%, Ti 1%, Ta 6%, Ni complément à 100. On applique à l'alliage un traitement thermique de mise en solution complète de la phase $\gamma'$ de type $Ni_3$ Al et un traitement de précipitation à une température supérieure à 1000°C, de préférence entre 1020°C et 1120°C pendant quelques heures, suivi d'un traitement complémentaire à une température de l'ordre de 850°C.

Le but de l'invention est de proposer une nouvelle famille d'alliages du type précité et de densité voisine de 8,6 présentant des caractéristiques d'utilisation avantageuses, particulièrement en ce qui concerne la tenue au fluage à hautes températures.

Ce but est atteint conformément à l'invention par des alliages présentant la composition suivante:

| Co | 5 | à | 8% |
|---|---|---|---|
| Cr | 6,5 | à | 10% |
| Mo | 0,5 | à | 2,5% |
| W | 5 | à | 9% |
| Ta | 6 | à | 9% |
| Al | 4,5 | à | 5,8% |
| Ti | 1 | à | 2% |
| Nb | 0 | à | 1,5% |
| C, Zr, B | chacun inférieur à 100 ppm | | |
| Ni | complément à 100 | | |

ces pourcentages étant exprimés en poids, avec par ailleurs la somme des pourcentages pondéraux Ta + Mo + $\frac{1}{2}$ W comprise entre 11,5 et 13,5%, la somme des pourcentages atomiques Ti + Al + Ta + Nb comprise entre 15,5 et 17%, la somme des pourcentages atomiques Ta + Nb + Mo + $\frac{1}{2}$ W comprise entre 4 et 5,5%, la somme des pourcentages atomiques Ti + Al + Ta + Nb + Mo + $\frac{1}{2}$ W comprise entre 17,5 et 19% et la somme des pourcentages atomiques Ti + Al comprise entre 12,8 et 14,5%.

Les alliages de l'invention présentent une structure composée essentiellement de deux phases: matrice $\gamma$ et phase durcissante $\gamma'$ (composé du type $Ni_3$ Al). Ces alliages permettent la remise en solution du $\gamma'$ par un traitement à très haute température: il existe en effet un écart de température suffisant entre la fin de mise en solution du $\gamma'$ et le début de fusion de l'alliage. Cet intervalle de remise en solution du $\gamma'$ (différence de température entre le solvus et le solidus) obtenu selon l'invention est de trente degrés. Le traitement thermique se complète de deux revenus permettant la reprécipitation de la phase $\gamma'$ sous la forme désirée.

Plutôt que d'ajuster les paramètres des phases $\gamma$ et $\gamma'$ par une étude de l'influence des éléments pris individuellement, un ensemble de compositions a été essayé afin de définir le comportement synergétique de l'ensemble des éléments contrôlant la phase durcissante. L'objectif était de trouver une famille des compositions qui puissent assurer une fraction de $\gamma'$ élevée (supérieure à 60%) et une répartition judicieuse entre les phases $\gamma$ et $\gamma'$ de certains éléments qui influencent de manière critique les paramètres cristallins de chacune de ces phases. Cette démarche a conduit à définir des critères reliant plusieurs éléments constitutifs des alliages qui sont finalement plus importants que les fourchettes individuelles de composition et ces critères se justifient par le niveau élevé des résultats obtenus par les alliages qui y répondent, en particulier concernant leur tenue au fluage.

Bien que de ce fait une justification détaillée des fourchettes de composition retenues pour chaque élément soit inadéquate pour rendre compte de l'effet synergétique de la composition globale, on va tenter cependant ci-après de justifier les choix principaux et de fournir des exemples de réalisation, en référence aux dessins annexés sur lesquels:

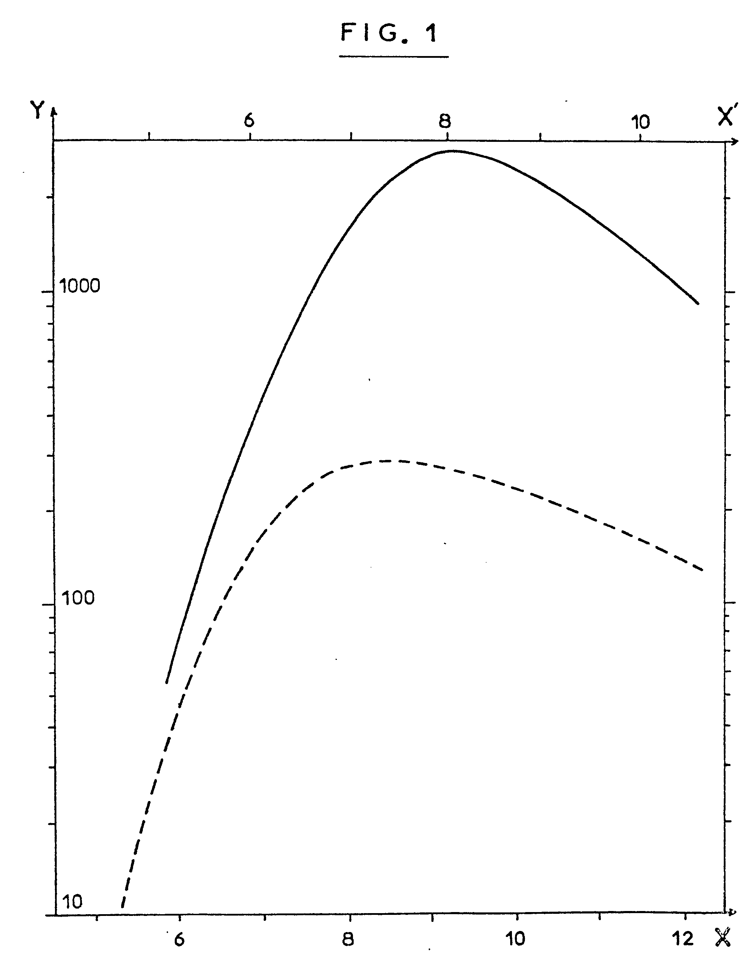

– la figure 1 est un graphique permettant d'apprécier l'influence de la teneur en chrome sur la résistance au fluage d'un alliage monocristallin à base nickel. Les abscisses X et X' donnent le pourcentage atomique et pondéral en chrome, tandis que les ordonnées Y donnent le temps nécessaire, en heures, pour obtenir 1% de déformation d'une éprouvette sous les conditions suivantes: 850°C et 500 MPa pour la courbe en trait plein, 1050°C et 120 MPa pour la courbe en pointillés.

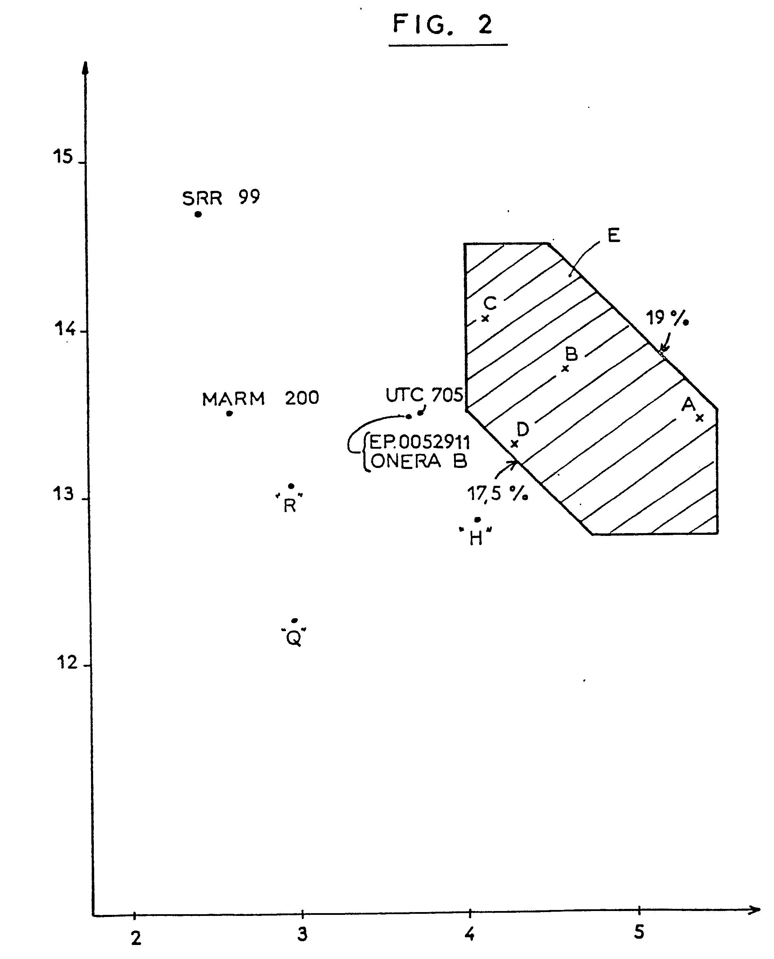

– la figure 2 est un graphique présentant en abscisse la somme des pourcentages atomiques Ta + Nb + Mo + $\frac{1}{2}$ W et en ordonnée la somme des pourcentages atomiques Ti + Al et dans lequel ont été situés les points correspondants à des alliages de l'invention et à des alliages connus, permettant ainsi de déterminer un domaine particulier du plan dans lequel se situent les alliages de l'invention,

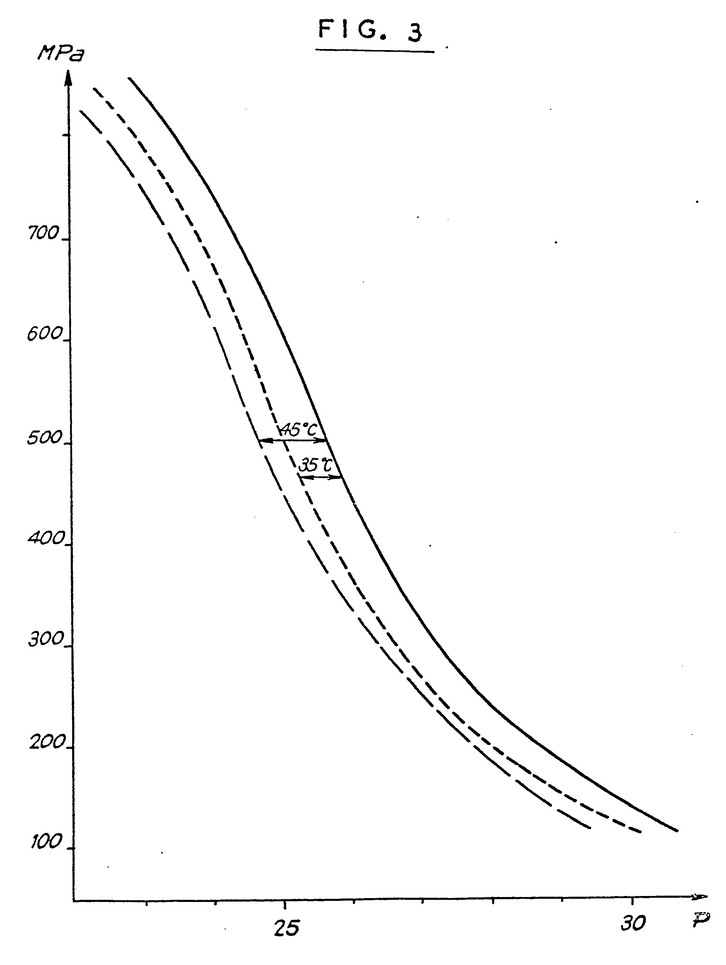

– la figure 3 est un diagramme de Larson-Miller reportant les résultats d'essais comparatifs de fluage. Il donne la variation du paramètre P = T (20 + logt) · $10^{-3}$ où T est la température absolue en °K, et t le temps en heures, en fonction de la contrainte exprimée en MPa. La courbe en trait plein correspond à un alliage de l'invention; les courbes en traits respectivement courts et longs correspondent à des alliages connus.

L'introduction de cobalt dans l'alliage de l'invention permet d'augmenter la solubilité des éléments durcissants (W, Mo, Ta) dans l'alliage, ce qui conduit à une meilleure tenue au fluage. La présence de cobalt permet d'assurer la stabilité de l'alliage à haute température. On a constaté dans des alliages voisins, mais ne contenant pas de cobalt des précipités tels que $\alpha$ W, $\alpha$ Cr ou $\beta$ lors de maintien à haute température. Une teneur en cobalt dans cet alliage comprise entre 5 et 8%, et préférentiellement entre 6 et 8%, qui évite ces inconvénients est indiquée.

La composition en chrome des alliages retenus doit être comprise entre 6,5 et 10% et préférentiellement entre 6,5 et 8% afin d'optimiser la résistance au fluage allongement de l'alliage (cf. figure 1) à 850°C et 1050°C. Les courbes de la figure 1, déterminées expérimentalement, montrent en effet que la tenue à haute température de l'alliage s'accroît lorsque la teneur en chrome augmente mais au-delà d'une teneur pondérale d'environ 10%, l'influence du chrome devient néfaste.

Les éléments molybdène, tungstène et tantale permettent de durcir l'alliage, c'est-à-dire d'améliorer la résistance au fluage à toutes températures. Un critère tel que la somme (% Ta + % Mo + $^1/_2$% W) permet d'estimer le durcissement. On a retenu les alliages ayant la somme des teneurs en ces éléments la plus grande possible. Elle est cependant limitée par le besoin d'avoir un alliage de densité plutôt proche de 8,5 que de 9 et par le fait qu'avec de très grandes teneurs en W, Mo ou Ta l'alliage ne sera plus métallurgiquement stable (apparition de phases riches en Ta ou W par exemple). Il est préconisé de choisir la somme (% Ta + % Mo + $^1/_2$% W) dans la fourchette 11,5 à 13,5% en poids. Cette fourchette a été déterminée expérimentalement.

Dans le domaine de concentration en éléments durcissants défini ci-dessus, il est intéressant de mettre une certaine quantité de molybdène (teneur comprise entre 0,5% et 2,5% et préférentiellement entre 1% et 2,5%) pour augmenter les propriétés de fluage à haute température (au-dessus de 900°C). Le molybdène confère une meilleure résistance à la matrice de nickel dans laquelle il ségrège préférentiellement.

Dans le même domaine, le tungstène est retenu pour sa contribution à la stabilité de la phase $\gamma'$ mentionnée précédemment. Cet élément accroît par conséquent les propriétés de l'alliage mais sa teneur reste limitée par le risque de faire précipiter la phase $\alpha$ W néfaste pour l'alliage, d'où il résulte une teneur comprise entre 5 et 9% et préférentiellement entre 5 et 8%.

Les bonnes propriétés des alliages étudiés sont liées à la quantité de phase $\gamma'$ précipitée. Il y aura d'autant plus de phase précipitée que la somme des teneurs en Al, Ti, Ta et Nb qui sont des éléments $\gamma'$-gènes sera importante. La valeur de cette somme ne pourra être augmentée au-delà d'une certaine valeur sinon la solidification de l'alliage en sera changée: il se forme de plus en plus d'eutectique $\gamma/\gamma'$ en fin de solidification et la mise en solution de la phase $\gamma'$ par traitement thermique devient insuffisante. La fourchette de variation de la somme Ti + Al + Ta + Nb en pourcentage atomique est la suivante: valeur minimale 15,5% et valeur maximale 17%. La composition atomique est retenue dans la mesure où il s'agit de contrôler une fraction de phase Ni $\gamma'$ qui se forme et dont la composition est du type Ni$_3$ (Ti, Al, Nb, Ta).

Dans le domaine de composition en éléments $\gamma'$-gènes déterminé ci-dessus, il importe que la composition en titane soit au moins de 1% en poids (préférentiellement au moins de 1,1%) et au plus de 2%. Il a en effet été montré que dans les alliages où le titane était remplacé par l'aluminium, la résistance au fluage entre 750 et 1050°C était diminuée. En conséquence, le titane est introduit en remplacement de l'aluminium pour augmenter la tenue mécanique, notamment à haute température. L'aluminium se situe ainsi en poids entre 4,5 et 5,8% et préférentiellement entre 5 et 5,5%.

Le tantale d'une part augmente la fraction volumique de $\gamma'$ et d'autre part durcit l'alliage en général. Il est donc intéressant que sa teneur soit d'au moins 6% en poids. Par contre, elle doit être limitée à 9% et préférentiellement à 8% pour ne pas augmenter trop la densité de l'alliage.

Le niobium dans ces alliages augmente la résistance en fluage allongement vers les basses températures 750–850°C sans nuire aux propriétés à haute température. Une addition de niobium jusqu'à 1,5% en poids est souhaitable et préférentiellement cette teneur est limitée à 1%. Dans certains cas, une teneur minimale de 0,5% est recherchée.

Le critère concernant les éléments durcissants qui a été déterminé ci-dessus est complété par un critère supplémentaire qui intègre l'influence du niobium, sous la forme d'une somme de pourcentages atomiques (%Ta + %Nb + %Mo + $^1/_2$% W) dans la fourchette de 4 à 5,5%.

Le critère concernant la somme des teneurs en éléments $\gamma'$-gènes est également complété par un autre critère supplémentaire qui particularise l'influence des éléments légers, sous la forme de variation de la somme Ti + Al en pourcentage atomique dans une fourchette de 12,8 à 14,5%.

Enfin, une fourchette de variation de la somme, en pourcentage atomique, de tous les éléments concernés par les critères précédents, à savoir Al + Ti + Nb + Ta + Mo + $^1/_2$ W, a été déterminée expérimentalement comprise entre 17,5 et 19%.

A titre d'exemple, il a été étudié plus particulièrement quatre alliages A, B, C et D de la famille conforme à l'invention. Leur composition est donnée dans le tableau 1 ci-après, où les teneurs sont exprimées en pourcentage pondéral sauf pour la somme Al + Ti + Ta + Nb qui est en pourcentages atomiques.

A la figure 2, on a donné une représentation graphique des trois dernières fourchettes qui ont été définies ci-dessus. Sur ce graphique, les alliages sont représentés par leur teneur en pourcentage atomique en éléments légers $\gamma'$-gènes Al + Ti reportée en ordonnées et par leur teneur en pourcentage atomique en éléments influençant directement ou indirectement la précipitation de la phase durcissante $\gamma'$, Ta + Nb + Mo + $^{1}/_{2}$ W, reportée en abscisse. Les fourchettes correspondantes déterminées expérimentalement délimitent sur ce graphique un domaine E représenté par une zone hachurée. A l'intérieur de ce domaine E qui correspond aux alliages de l'invention répondant aux trois fourchettes définies, ont été reportés les points correspondants aux quatre alliages A, B, C et D de la famille conforme à l'invention et les valeurs correspondantes des sommes en pourcentage atomique sont données dans le tableau 2. En comparaison avec les alliages de l'invention, on a reporté également sur le graphique de la figure 2 les points correspondants à des alliages connus: SRR99 (source ROLLS ROYCE), MAR M 200 alliage du brevet EP-A 0 052 911, exemple B du brevet FR-A 2 503 188 au nom de ONERA, et les exemples R, Q, H et 705 du brevet FR-A 2 512 837 au nom de United Technologies Corporation. Tous ces alliages connus se trouvent en dehors du domaine E déterminé pour les alliages de l'invention. Cette situation est corroborée par les résultats obtenus comme on le verra plus en détail plus loin.

Sur les alliages élaborés sous la forme de monocristaux, il est nécessaire de faire subir une séquence de traitements thermiques afin d'optimiser les propriétés. L'objectif de ces traitements est d'établir une distribution homogène des précipités de $\gamma'$ d'un diamètre moyen de l'ordre de 0,4 à 0,6 µm. Les inventeurs ont montré l'importance d'une taille maximale de $\gamma'$ à ne pas dépasser sous peine de perdre en résistance au fluage.

Le traitement thermique débute par une mise en solution du $\gamma'$ qui doit être la plus complète possible. Elle s'effectue à une température légèrement inférieure à la température de fusion commençante. Typiquement, pour les quatre alliages qui ont été cités ci-dessus, elle se fera à 1280°C pendant six heures pour les alliages A et D, à 1310°C pendant quatre heures pour l'alliage B, à 1300°C pendant quatre heures pour l'alliage C. La mise en solution se termine par une trempe empêchant la formation de $\gamma'$ de taille supérieure à 0,3 µm. Il est nécessaire que le refroidissement ait lieu au moins à une vitesse de l'ordre de dix degrés par seconde en tout point de la pièce.

Deux revenus permettent la précipitation du $\gamma'$. Le premier revenu est ajusté de façon à obtenir une répartition unimodale du $\gamma'$ d'une taille moyenne de 0,5 µm environ. Plusieurs conditions en température-temps peuvent être retenues dans ce but notamment de 1100°C – 3 à 10 heures jusqu'à 1050°C – 10 à 24 heures, mais le meilleur traitement semble être 1100°C – 5 heures dans la mesure où la forme des précipités est moins régulière lorsque la température de revenu est plus élevée et qu'à plus basse température, le temps de revenu augmente beaucoup. Le second revenu de précipitation se déroule vers 850°C pendant 15 à 25 heures.

Les trois alliages A, B et C ont été testés au fluage à 760°C, 950°C et 1050°C et l'alliage D à 760°C et 950°C. Les résultats donnés dans le tableau 3 ci-après ont été reportés sur la figure 3 dans un diagramme de Larson-Miller en comparaison avec l'alliage connu sous le nom de MARM 200 à structure monocristalline (courbe en traits longs), et l'alliage à structure monocristalline selon le brevet EP-A 0 052 911 (courbe en traits courts, source CANNON-MUSKEGON); le diagramme laisse apparaître l'intérêt des alliages de l'invention: un gain de 45°C environ sur le MARM 200 et de 35°C environ sur l'alliage CANNON-MUSKEGON.

Tableau 1

| Alliage | Ni | Co | Cr | Mo | W | Ta | Al | Ti | Nb | ½ W + Ta + Mo | Al + Ti + Ta + Nb (%at) |
|---|---|---|---|---|---|---|---|---|---|---|---|
| A | base | 8 | 7 | 2 | 5 | 8 | 5 | 1,8 | 1 | 12,5 | 16,7 |
| B | base | 7,5 | 7 | 2 | 8 | 6 | 5,3 | 1,5 | – | 12 | 15,8 |
| C | base | 6,5 | 7,5 | 1,5 | 7 | 6,5 | 5,3 | 1,8 | – | 11,5 | 16,2 |
| D | base | 5 | 10 | 0,5 | 6 | 9 | 5,25 | 1,25 | – | 12,5 | 16,25 |

Tableau 2

| Alliage | Sommes en pourcentage atomique | | |
|---|---|---|---|
| | Al + Ti | Nb + Ta + Mo + ½ W | Al + Ti + Nb + Ta + Mo + ½ W |
| A | 13,45 | 5,40 | 18,85 |
| B | 13,75 | 4,60 | 18,35 |
| C | 14,05 | 4,25 | 18,30 |
| D | 13,30 | 4,30 | 17,60 |

Tableau 3

| Alliages | Conditions de fluage Température (°C) | Contrainte (MPa) | Resultats Temps pour 1% de déformation (h) | Temps à rupture (h) |
|---|---|---|---|---|
| A | 760 | 750 | 202 | 857 |
|  | 950 | 240 | 228 | 545 |
|  | 1050 | 120 | 1004 | 1073 |
|  | 1050 | 140 | 304 | 338 |
| B | 760 | 840 | 48 | 410 |
|  | 950 | 240 | 247 | 603 |
|  | 1050 | 140 | 430 | 496 |
| C | 760 | 750 | 330 | 1000 |
|  | 950 | 240 | 194 | 480 |
|  | 1050 | 140 | 365 | 435 |
| D | 760 | 750 | 151 | 732 |
|  | 950 | 240 | 175 | 528 |
| EP-A 0 052 911 | 760 | 750 | 55 | 560 |
|  | 950 | 240 | 100 | 253 |
|  | 1050 | 120 | 320 | 460 |
| MAR M 200 | 760 | 750 | 10 | 250 |
|  | 950 | 240 | 55 | 170 |
|  | 1050 | 120 | 85 | 140 |

**Revendications**

1. Alliage monocristallin à haute résistance au fluage à matrice à base de nickel, de densité voisine de 8,6, sans addition intentionnelle de carbone, de bore et de zirconium, dans lequel la composition est définie par les pourcentages pondéraux des éléments suivants:

| | | | |
|---|---|---|---|
| Co | 5 | à | 8% |
| Cr | 6,5 | à | 10% |
| Mo | 0,5 | à | 2,5% |
| W | 5 | à | 9% |
| Ta | 6 | à | 9% |
| Al | 4,5 | à | 5,8% |
| Ti | 1 | à | 2% |
| Nb | 0 | à | 1,5% |
| C, Zr, B | chacun inférieur à 100 ppm | | |
| Ni | complément à 100 | | |

et la somme des pourcentages en poids de Ta + Mo + $\frac{1}{2}$ W est comprise entre 11,5% et 13,5%, la somme Ti + Al + Ta + Nb en pourcentages atomiques est comprise entre 15,5 et 17%, la somme des pourcentages atomiques Ta + Nb + Mo + $\frac{1}{2}$ W est comprise entre 4 et 5,5%, la somme des pourcentages atomiques Ti + Al + Ta + Nb + Mo + $\frac{1}{2}$ W est comprise entre 17,5 et 19%, et la somme des pourcentages atomiques Ti + Al est comprise entre 12,8 et 14,5%.

2. Alliage selon la revendication 1 dans lequel les pourcentages pondéraux des éléments de composition sont limités aux valeurs suivantes:

| | | | |
|---|---|---|---|
| Co | 6 | à | 8% |
| Cr | 6,5 | à | 8% |
| Mo | 1 | à | 2,5% |
| W | 5 | à | 8% |
| Ta | 6 | à | 8% |
| Al | 5 | à | 5,5% |
| Ti | 1,1 | à | 2% |
| Nb | 0 | à | 1% |
| Ni | complément à 100. | | |

3. Alliage selon l'une des revendications 1 ou 2 présentant la composition suivante:

| | | |
|---|---|---|
| Co | 8% | en poids |
| Cr | 7% | en poids |
| Mo | 2% | en poids |
| W | 5% | en poids |
| Ta | 8% | en poids |
| Al | 5% | en poids |
| Ti | 1,8% | en poids |
| Nb | 1% | en poids |
| Le reste Ni, | | |
| $\frac{1}{2}$ W + Ta + Mo: | 12,5% | en poids |
| Al + Ti + Ta + Nb: | 16,7% | en pourcentage atomique |
| Ta + Nb + Mo + $\frac{1}{2}$ W: | 5,4% | en pourcentage atomique |
| Ti + Al + Ta + Nb + Mo + $\frac{1}{2}$ W: | 18,85% | en pourcentage atomique. |
| Ti + Al: | 13,45% | en pourcentage atomique. |

4. Alliage selon l'une des revendications 1 à 2 présentant la composition suivante:

| | | |
|---|---|---|
| Co | 7,5% | en poids |
| Cr | 7% | en poids |
| Mo | 2% | en poids |

| | | |
|---|---|---|
| W | 8% | en poids |
| Ta | 6% | en poids |
| Al | 5,3% | en poids |
| Ti | 1,5% | en poids |
| Nb | 0% | en poids |
| Le reste Ni | | |
| ½ W + Ta + Mo: | 12% | en poids |
| Al + Ti + Ta + Nb: | 15,8% | en pourcentage atomique |
| Ta + Nb + Mo + ½ W: | 4,60% | en pourcentage atomique |
| Ti + Al + Ta + Nb + Mo + ½ W: | 18,35% | en pourcentage atomique |
| Ti + Al: | 13,75% | en pourcentage atomique. |

5. Alliage selon l'une des revendications 1 ou 2 présentant la composition suivante:

| | | |
|---|---|---|
| Co | 6,5% | en poids |
| Cr | 7,5% | en poids |
| Mo | 1,5% | en poids |
| W | 7% | en poids |
| Ta | 6,5% | en poids |
| Al | 5,3% | en poids |
| Ti | 1,8% | en poids |
| Nb | 0% | |
| Le reste Ni | | |
| ½ W + Ta + Mo: | 11,5% | en poids |
| Al + Ti + Ta + Nb: | 16,2% | en pourcentage atomique |
| Ta + Nb + Mo + ½ W: | 4,25% | en pourcentage atomique |
| Ti + Al + Ta + Nb + Mo + ½ W: | 18,30% | en pourcentage atomique |
| Ti + Al: | 14,05% | en pourcentage atomique. |

6. Alliage selon la revendication 1 présentant la composition suivante:

| | | |
|---|---|---|
| Co | 5% | en poids |
| Cr | 10% | en poids |
| Mo | 0,5% | en poids |
| W | 6% | en poids |
| Ta | 9% | en poids |
| Al | 5,25% | en poids |
| Ti | 1,25% | en poids |
| Nb | 0% | |
| Le reste Ni | | |
| ½ W + Ta + Mo: | 12,5% | en poids |
| Al + Ti + Ta + Nb: | 16,25% | en pourcentage atomique |
| Ta + Nb + Mo + ½ W: | 4,30% | en pourcentage atomique |
| Ti + Al + Ta + Nb + Mo + ½ W: | 17,60% | en pourcentage atomique |
| Ti + Al: | 13,30% | en pourcentage atomique. |

7. Alliage selon la revendication 1, caractérisé en ce que le pourcentage en poids de Nb est compris entre 0,5 et 1,5%.

8. Alliage selon l'une quelconque des revendications 1 à 7, auquel on fait subir un traitement thermique à haute température de mise en solution complète de la phase gamma-prime, suivi d'une trempe de précipitation de la phase gamma-prime empêchant la formation de gamma-prime de taille supérieure à 0,3 μm, complété par deux revenus.

9. Alliage selon les revendications 3 ou 6 et 8, caractérisé en ce qu'on lui fait subir un traitement thermique à 1280 °C pendant 6 heures de mise en solution complète de la phase gamma-prime.

10. Alliage selon les revendications 4 et 8, caractérisé en ce qu'on lui fait subir un traitement thermique à 1310 °C pendant quatre heures de mise en solution complète de la phase gamma-prime.

11. Alliage selon les revendications 5 et 8, caractérisé en ce qu'on lui fait subir un traitement thermique à 1300 °C pendant quatre heures de mise en solution complète de la phase gamma-prime.

12. Alliage selon l'une quelconque des revendications 8 à 11, caractérisé en ce que le premier revenu a lieu vers 1100 °C pendant 3 à 10 heures.

13. Alliage selon l'une quelconque des revendications 8 à 12, caractérisé en ce que le second revenu a lieu à 850 °C pendant 15 à 25 heures.

**Claims**

1. Monocrystalline alloy with high resistance to plastic flow, having a nickel-based matrix, having a density close to 8.6, without intentional addition of carbon, of boron and of zirconium, in which the composition is defined by the following percentages by weight of the elements:

| | | | |
|---|---|---|---|
| Co | 5 | to | 8% |
| Cr | 6.5 | to | 10% |
| Mo | 0.5 | to | 2.5% |
| W | 5 | to | 9% |
| Ta | 6 | to | 9% |
| Al | 4.5 | to | 5.8% |
| Ti | 1 | to | 2% |
| Nb | 0 | to | 1.5% |
| C, Zr, B | each below 100 ppm | | |
| Ni | balanced to 100 | | |

and the sum of the percentages by weight of Ta + Mo + ½ W is within the range between 11.5% and 13.5%, the sum Ti + Al + Ta + Nb in atomic percentages is within the range between 15.5 and 17%, the sum of the atomic percentages Ta + Nb + Mo + ½ W is within the range between 4 and 5.5%, the sum of the atomic percentages Ti + Al + Ta + Nb + Mo + ½ W is within the range between 17.5 and 19%, and the sum of the atomic percentages Ti + Al is within the range between 12.8 and 14.5%.

2. Alloy according to Claim 1, in which the percentages by weight of the elements included in the composition are limited to the following values:

| Co | 6 | to | 8% |
|---|---|---|---|
| Cr | 6.5 | to | 8% |
| Mo | 1 | to | 2.5% |
| W | 5 | to | 8% |
| Ta | 6 | to | 8% |
| Al | 5 | to | 5.5% |
| Ti | 1.1 | to | 2% |
| Nb | 0 | to | 1% |
| Ni | balanced to 100. | | |

3. Alloy according to one of Claims 1 or 2, having the following composition:

| Co | 8% | by weight |
|---|---|---|
| Cr | 7% | by weight |
| Mo | 2% | by weight |
| W | 5% | by weight |
| Ta | 8% | by weight |
| Al | 5% | by weight |
| Ti | 1.8% | by weight |
| Nb | 1% | by weight |
| The balance Ni, | | |
| ½ W + Ta + Mo: | 12.5% | by weight |
| Al + Ti + Ta + Nb: | 16.7% | by atomic percentage |
| Ta + Nb + Mo + ½ W: | 5.4% | by atomic percentage |
| Ti + Al + Ta + Nb + Mo + ½ W: | 18.85% | by atomic percentage |
| Ti + Al: | 13.45% | by atomic percentage. |

4. Alloy according to one of Claims 1 to 2, having the following composition:

| Co | 7.5% | by weight |
|---|---|---|
| Cr | 7% | by weight |
| Mo | 2% | by weight |
| W | 8% | by weight |
| Ta | 6% | by weight |
| Al | 5.3% | by weight |
| Ti | 1.5% | by weight |
| Nb | 0% | by weight |
| The balance Ni, | | |
| ½ W + Ta + Mo: | 12% | by weight |
| Al + Ti + Ta + Nb: | 15.8% | by atomic percentage |
| Ta + Nb + Mo + ½ W: | 4.60% | by atomic percentage |
| Ti + Al + Ta + Nb + Mo + ½ W: | 18.35% | by atomic percentage |
| Ti + Al: | 13.75% | by atomic percentage. |

5. Alloy according to one of Claims 1 or 2, having the following compostion:

| Co | 6.5% | by weight |
|---|---|---|
| Cr | 7.5% | by weight |
| Mo | 1.5% | by weight |
| W | 7% | by weight |
| Ta | 6.5% | by weight |
| Al | 5.3% | by weight |
| Ti | 1.8% | by weight |
| Nb | 0% | |
| The balance Ni, | | |
| ½ W + Ta + Mo: | 11.5% | by weight |
| Al + Ti + Ta + Nb: | 16.2% | by atomic percentage |
| Ta + Nb + Mo + ½ W: | 4.25% | by atomic percentage |
| Ti + Al + Ta + Nb + Mo + ½ W: | 18.30% | by atomic percentage |
| Ti + Al: | 14.05% | by atomic percentage. |

6. Alloy according to Claim 1, having the following composition:

| Co | 5% | by weight |
|---|---|---|
| Cr | 10% | by weight |
| Mo | 0.5% | by weight |
| W | 6% | by weight |
| Ta | 9% | by weight |
| Al | 5.25% | by weight |
| Ti | 1.25% | by weight |
| Nb | 0% | |
| The balance Ni, | | |
| ½ W + Ta + Mo: | 12.5% | by weight |
| Al + Ti + Ta + Nb: | 16.25% | by atomic percentage |
| Ta + Nb + Mo + ½ W: | 4.30% | by atomic percentage |
| Ti + Al + Ta + Nb + Mo + ½ W: | 17.60% | by atomic percentage |
| Ti + Al: | 13.30% | by atomic percentage. |

7. Alloy according to Claim 1, characterized in that the percentage by weight of Nb is within the range between 0.5 and 1.5%.

8. Alloy according to any one of Claims 1 to 7, which is subjected to a heat treatment at high temperature for the complete solution of the gamma-prime phase, followed by a precipitation hardening of the gamma-prime phase preventing the formation of gamma-prime of size exceeding 0.3 µm, completed by two annealings.

9. Alloy according to Claims 3 or 6 and 8, characterized in that it is subjected to a heat treatment at 1280 °C for 6 hours for the complete solution of the gamma-prime phase.

10. Alloy according to Claims 4 and 8, characterized in that it is subjected to a heat treatment at 1310 °C for four hours for the complete solution of the gamma-prime phase.

11. Alloy according to Claims 5 and 8, characterized in that it is subjected to a heat treatment at 1300 °C for four hours for the complete solution of the gamma-prime phase.

12. Alloy according to any one of Claims 8 to 11, characterized in that the first annealing takes place at approximately 1100 °C for 3 to 10 hours.

13. Alloy according to any one of Claims 8 to 12, characterized in that the second annealing takes place at 850 °C for 15 to 25 hours.

**Patentansprüche**

1. Monokristalline Legierung mit hoher Standfestigkeit mit einer Matrix auf Nickelbasis, einer Dichte nahe 8,6, ohne vorsätzliche Zugabe von Kohlenstoff, Bor und Zirkon, bei der die Zusammensetzung durch die Gewichtsprozente der Elemente folgendermaßen definiert ist:

| | | | |
|---|---|---|---|
| Co | 5,0 | bis | 8,0% |
| Cr | 6,5 | bis | 10,0% |
| Mo | 0,5 | bis | 2,5% |
| W | 5,0 | bis | 9,0% |
| Ta | 6,0 | bis | 9,0% |
| Al | 4,5 | bis | 5,8% |
| Ti | 1,0 | bis | 2,0% |
| Nb | 0,0 | bis | 1,5% |
| C, Zr, B | jedes weniger als 100 ppm | | |
| Ni | ergänzend auf 100% | | |

und die Summe der Gewichtsprozente von Ta + Mo + $\frac{1}{2}$ W zwischen 11,5% und 13,5%, die Summe von Ti + Al + Ta + Nb in Atomprozenten zwischen 15,5 und 17%, die Summe der Atomprozente von Ta + Nb + Mo + $\frac{1}{2}$ W zwischen 4 und 5,5%, die Summe der Atomprozente von Ti + Al + Ta + Nb + Mo + $\frac{1}{2}$ W zwischen 17,5 und 19%, und die Summe der Atomprozente von Ti + Al zwischen 12,8 und 14,5% liegen.

2. Legierung nach Anspruch 1, bei der die Gewichtsprozente der Elemente der Zusammensetzung durch folgende Werte begrenzt sind:

| | | | |
|---|---|---|---|
| Co | 6,0 | bis | 8,0% |
| Cr | 6,5 | bis | 8,0% |
| Mo | 1,0 | bis | 2,5% |
| W | 5,0 | bis | 8,0% |
| Ta | 6,0 | bis | 8,0% |
| Al | 5,0 | bis | 5,5% |
| Ti | 1,1 | bis | 2,0% |
| Nb | 0,0 | bis | 1,0% |
| Ni | ergänzend auf 100%. | | |

3. Legierung nach einem der Ansprüche 1 oder 2, die folgende Zusammensetzung enthält:

| | |
|---|---|
| Co | 8,0 Gew.-% |
| Cr | 7,0 Gew.-% |
| Mo | 2,0 Gew.-% |
| W | 5,0 Gew.-% |
| Ta | 8,0 Gew.-% |
| Al | 5,0 Gew.-% |
| Ti | 1,8 Gew.-% |
| Nb | 1,0 Gew.-% |
| Rest Ni; | |
| $\frac{1}{2}$ W + Ta + Mo: | 12,5 Gew.-% |
| Al + Ti + Ta + Nb: | 16,7% At.-% |
| Ta + Nb + Mo + $\frac{1}{2}$ W: | 5,4% At.-% |
| Ti + Al + Ta + Nb + Mo + $\frac{1}{2}$ W: | 18,85% At.-% |
| Ti + Al: | 13,45% At.-% |

4. Legierung nach einem der Ansprüche 1 und 2, die folgende Zusammensetzung enthält:

| | |
|---|---|
| Co | 7,5 Gew.-% |
| Cr | 7,0 Gew.-% |
| Mo | 2,0 Gew.-% |
| W | 8,0 Gew.-% |
| Ta | 6,0 Gew.-% |
| Al | 5,3 Gew.-% |
| Ti | 1,5 Gew.-% |
| Nb | 0,0 Gew.-% |
| Rest Ni; | |
| $\frac{1}{2}$ W + Ta + Mo: | 12 Gew.-% |
| Al + Ti + Ta + Nb: | 15,8% At.-% |
| Ta + Nb + Mo + $\frac{1}{2}$ W: | 4,6% At.-% |
| Ti + Al + Ta + Nb + Mo + $\frac{1}{2}$ W: | 18,35% At.-% |
| Ti + Al: | 13,75% At.-% |

5. Legierung nach einem der Ansprüche 1 oder 2, die folgende Zusammensetzung enthält:

| | |
|---|---|
| Co | 6,5 Gew.-% |
| Cr | 7,5 Gew.-% |
| Mo | 1,5 Gew.-% |
| W | 7,0 Gew.-% |
| Ta | 6,5 Gew.-% |
| Al | 5,3 Gew.-% |
| Ti | 1,8 Gew.-% |
| Nb | 0,0 Gew.-% |
| Rest Ni; | |
| $\frac{1}{2}$ W + Ta + Mo: | 11,5 Gew.-% |
| Al + Ti + Ta + Nb: | 16,2% At.-% |
| Ta + Nb + Mo + $\frac{1}{2}$ W: | 4,25% At.-% |
| Ti + Al + Ta + Nb + Mo + $\frac{1}{2}$ W: | 18,30% At.-% |
| Ti + Al: | 14,05% At.-% |

6. Legierung nach Anspruch 1, die folgende Zusammensetzung enthält:

| | |
|---|---|
| Co | 5,0 Gew.-% |
| Cr | 10,0 Gew.-% |
| Mo | 0,5 Gew.-% |
| W | 6,0 Gew.-% |
| Ta | 9,0 Gew.-% |
| Al | 5,25 Gew.-% |
| Ti | 1,25 Gew.-% |
| Nb | 0,0 Gew.-% |
| Rest Ni; | |
| $\frac{1}{2}$ W + Ta + Mo: | 12,5 Gew.-% |
| Al + Ti + Ta + Nb: | 16,25% At.-% |
| Ta + Nb + Mo + $\frac{1}{2}$ W: | 4,30% At.-% |
| Ti + Al + Ta + Nb + Mo + $\frac{1}{2}$ W: | 17,60% At.-% |
| Ti + Al: | 13,30% At.-% |

7. Legierung nach Anspruch 1, dadurch gekennzeichnet, daß die Gewichtsprozente von Nb zwischen 0,5 und 1,5% liegen.

8. Legierung nach einem beliebigen der Ansprüche 1 bis 7, wobei diese einer Wärmebehandlung bei hoher Temperatur ausgesetzt wird wegen des vollständigen Übergangs in eine Lösung der Gamma-Primär-Phase gefolgt von einer Ausscheidungshärtung der Gamma-Primär-Phase um eine Bildung der Gamma-Primär-Phase von über 0,3 µm zu verhindern, vervollständigt durch zweimalige Wiederholung.

9. Legierung nach den Ansprüchen 3 oder 6 oder 8, dadurch gekennzeichnet, daß diese einer Wämebehandlung bei 1280 °C während 6 Stunden ausgesetzt wird wegen des vollständigen Überganges in eine Lösung der Gamma-Primär-Phase.

10. Legierung nach den Ansprüchen 4 und 8, dadurch gekennzeichnet, daß diese einer Wärmebehandlung bei 1310 °C während 4 Stunden ausgesetzt wird wegen des vollständigen Übergangs in eine Lösung der Gamma-Primär-Phase.

11. Legierung nach den Ansprüchen 5 und 8, dadurch gekennzeichnet, daß diese einer Wärmebehandlung bei 1300 °C während 4 Stunden ausgesetzt wird wegen des vollständigen Überganges in eine Lösung der Gamma-Primär-Phase.

12. Legierung nach einem der Ansprüche 8 bis 11, dadurch gekennzeichnet, daß die erste Wiederholung bei etwa 1100 °C während 3 bis 10 Stunden stattfindet.

13. Legierung nach einem der Ansprüche 8 bis 12, dadurch gekennzeichnet, daß die zweite Wiederholung bei 850 °C während 15 bis 25 Stunden stattfindet.

# FIG. 1

# FIG. 2

## FIG. 3